# EUROPÄISCHE PATENTSCHRIFT

(11) **EP 3 771 914 B1**
(45) Veröffentlichungstag und Bekanntmachung des Hinweises auf die Patenterteilung: **07.01.2026**
(21) Anmeldenummer: 20183665.7
(22) Anmeldetag: 02.07.2020
(51) Int. Cl.: G01R 31/327

(54) **SYSTEM UND VERFAHREN ZUR ÜBERWACHUNG DES ZUSTANDS EINES MAGNETSCHALTERS**
SYSTEM AND METHOD FOR MONITORING THE CONDITION OF A MAGNETIC SWITCH
SYSTÈME ET PROCÉDÉ DE SURVEILLANCE DE L'ÉTAT D'UN COMMUTATEUR MAGNÉTIQUE

(30) Priorität: 30.07.2019 DE 102019211286
(43) Veröffentlichungstag der Anmeldung: 03.02.2021
(73) Patentinhaber: BSH Hausgeräte GmbH, 81739 München (DE)
(72) Erfinder: Pacnik, Roman, 2383 Smartno pri Slovenj Gradcu (SI); Habe, Mitja, 3320 Velenje (SI); Rudez, Darko, 3230 Sentjur, Slowenien (SI)

(56) Entgegenhaltungen:
- DE-B3- 102016 107 598
- US-A1- 2011 228 438
- US-A1- 2014 002 093
- US-A1- 2016 291 075

## Beschreibung

Die Erfindung betrifft ein System und/oder ein Verfahren zur Überwachung und/oder zur Ermittlung des Zustands eines Magnetschalters, der z.B. in einem Hausgerät, insbesondere in einer Küchenmaschine, dazu verwendet wird, eine Komponente des Hausgeräts, z.B. einen Deckel, zu verriegeln.

Ein Hausgerät kann ein oder mehrere Komponenten aufweisen, die bei Bedarf verriegelt werden. Beispielsweise kann eine Küchenmaschine mit einem Behälter zur Aufnahme und/oder zur Verarbeitung von Nahrungsmitteln einen Deckel aufweisen, der verriegelt werden kann, um den Zugang zu dem Behälter zu unterbinden (z.B., wenn in dem Behälter ein Garprozess durchgeführt wird). Die Verriegelung kann durch einen Magnetschalter bewirkt werden.

DE 10 2016 107 598 B3 beschreibt ein Verfahren zum Überwachen eines Hochvolt-Schützes. US 2014 / 0002093 A1 beschreibt ein Verfahren zur Überwachung eines Schütz-Kontaktes.

Das vorliegende Dokument befasst sich mit der technischen Aufgabe, in effizienter und zuverlässiger Weise den Zustand eines Magnetschalters zu ermitteln und/oder zu überwachen, insbesondere um basierend darauf zu bestimmen, ob eine Komponente eines Hausgeräts verriegelt ist.

Die Aufgabe wird jeweils durch den Gegenstand der unabhängigen Patentansprüche gelöst. Vorteilhafte Ausführungsformen sind insbesondere in den abhängigen Patentansprüchen definiert, in nachfolgender Beschreibung beschrieben oder in der beigefügten Zeichnung dargestellt.

Die Erfindung ist ein System zum Betrieb eines (linearen) Magnetschalters wie in Anspruch 1 definiert.

Der Magnetschalter ist dabei insbesondere als Hubmagnet oder als Verriegelungsmagnet ausgebildet. Insbesondere kann der Magnetschalter ein Hubmagnet oder ein Verriegelungsmagnet sein. Gemäß einem Aspekt der Erfindung wird somit ein System zum Betrieb eines Hubmagneten oder eine Verriegelungsmagneten beschrieben. Der Magnetschalter (insbesondere der Hubmagnet oder der Verriegelungsmagnet) kann eine Spule umfassen, die eingerichtet ist, eine translatorische Bewegung eines (ferromagnetischen) Bolzens des Magnetschalters zu bewirken.

Insbesondere kann der Bolzen zwischen einer aus der Spule ausgefahrenen Position und einer in die Spule eingefahrenen Position bewegt werden. Der Magnetschalter (insbesondere der Hubmagnet oder der Verriegelungsmagnet) kann sich in einem ausgefahrenen Zustand befinden, wenn sich der Bolzen in der ausgefahrenen Position befindet, und in einem eingefahrenen Zustand befinden, wenn sich der Bolzen in der eingefahrenen Position befindet. Der Magnetschalter (insbesondere der Hubmagnet oder der Verriegelungsmagnet) kann bistabil ausgebildet sein, so dass der Magnetschalter stromlos in dem eingefahrenen Zustand und in dem ausgefahrenen Zustand gehalten werden kann.

Das System umfasst eine Ansteuerschaltung, die eingerichtet ist, einen Strom durch die Spule des Magnetschalters zu bewirken. Insbesondere kann die Ansteuerschaltung eingerichtet sein, eine Spannung an die Spule anzulegen, durch die dann ein Strom durch die Spule bewirkt wird. Der Strom durch die Spule bewirkt ein Magnetfeld durch das der Bolzen (je nach Polarität) in die ausgefahrene Position oder in die eingefahrene Position bewegt werden kann.

Das System umfasst ferner eine Messeinheit, die eingerichtet ist, Strominformation in Bezug auf den zeitlichen Verlauf des Stroms durch die Spule zu erfassen. Die Messeinheit kann z.B. einen Shunt-Widerstand, einen Hall-Sensor und/oder einen Transformator umfassen.

Des Weiteren umfasst das System eine Steuereinheit, die eingerichtet ist, die Ansteuerschaltung zu veranlassen, für einen Schalt- und/oder Überprüfungsvorgang des Magnetschalters einen Strom durch die Spule des Magnetschalters zu bewirken.

Insbesondere kann die Steuereinheit eingerichtet ist, die Ansteuerschaltung zu veranlassen, für einen Schaltvorgang einen Strom mit einer bestimmten (z.B. der ersten oder der zweiten) Polarität durch die Spule des Magnetschalters zu bewirken, um den Bolzen des Magnetschalters von der eingefahrenen Position zu der ausgefahrenen Position zu bewegen (und um den Magnetschalter von dem eingefahrenen Zustand in den ausgefahrenen Zustand zu überführen). Des Weiteren kann die Steuereinheit eingerichtet sein, die Ansteuerschaltung zu veranlassen, für einen Schaltvorgang einen Strom mit einer zu der bestimmten Polarität entgegengesetzten Polarität (z.B. der zweiten Polarität oder der ersten Polarität) durch die Spule des Magnetschalters zu bewirken, um den Bolzen des Magnetschalters von der ausgefahrenen Position zu der eingefahrenen Position zu bewegen (und um den Magnetschalter von dem ausgefahrenen Zustand in den eingefahrenen Zustand zu überführen).

Es kann somit ein Strom durch die Spule bewirkt werden, um einen Schaltvorgang des Magnetschalters (von dem ausgefahrenen Zustand in den eingefahrenen Zustand, oder umgekehrt, je nach Polarität des Stroms) zu bewirken. Des Weiteren kann, ggf. direkt im Anschluss an einen Schaltvorgang, für einen Überprüfungsvorgang des zuvor durchgeführten Schaltvorgangs ein Strom (der gleichen Polarität wie für den zuvor durchgeführten Schaltvorgang) bewirkt werden, um den Zustand des Magnetschalters zu überprüfen.

Die Steuereinheit kann eingerichtet sein, die Ansteuerschaltung zu veranlassen, für einen Schalt- und/oder Überprüfungsvorgang eine Spannung mit einer ersten Polarität oder mit einer (entgegengesetzten) zweiten Polarität an die Spule des Magnetschalters anzulegen. Durch die angelegte Spannung kann dann in zuverlässiger Weise ein Strom mit der jeweiligen Polarität durch die Spule bewirkt werden.

Die Steuereinheit ist ferner eingerichtet, den Zustand des Magnetschalters auf Basis der von der Messeinheit im Rahmen des Schalt- und/oder Überprüfungsvorgangs erfassten Strominformation zu bestimmen. Insbesondere kann durch die Messeinheit ein tatsächlicher zeitlicher Verlauf des Stroms während des Schalt- und/oder Überprüfungsvorgangs erfasst werden. Dabei kann der tatsächliche zeitliche Verlauf des Stroms durch eine Sequenz von Abtastwerten an einer entsprechenden Sequenz von Zeitpunkten beschrieben werden. Durch die Analyse des bei einem Schalt- und/oder Überprüfungsvorgang bewirkten Stroms durch die Spule eines Magnetschalters kann der Zustand des Magnetschalters (insbesondere ausgefahrener Zustand oder eingefahrener Zustand, oder eingeklemmter Zustand) in effizienter und zuverlässiger Weise ermittelt werden.

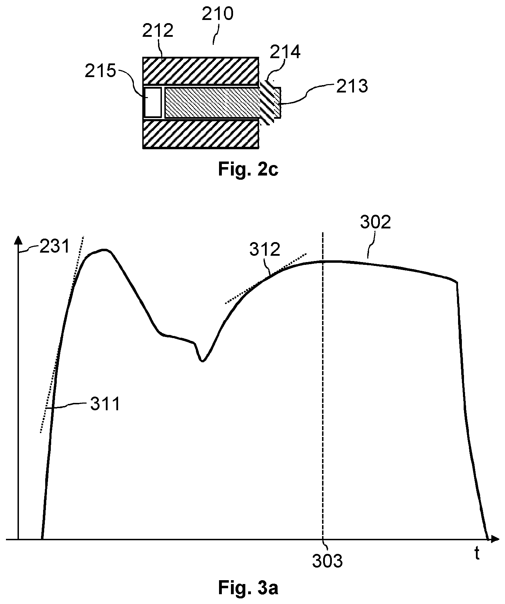

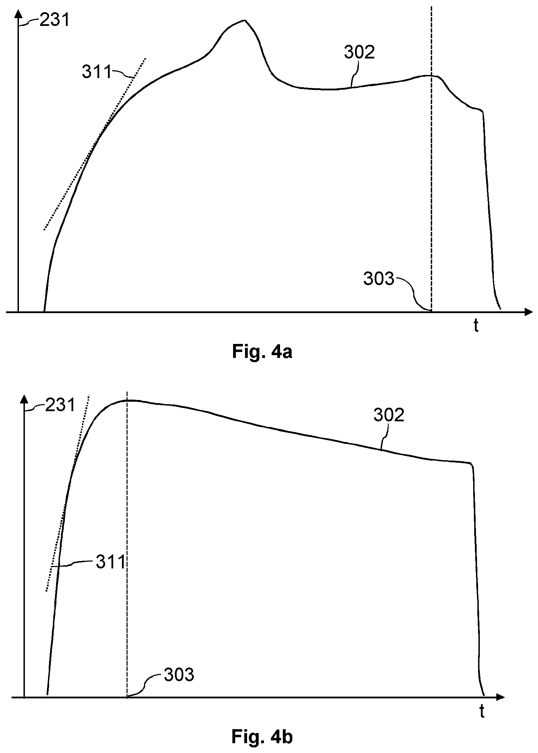

Die Steuereinheit kann eingerichtet sein, den durch die Strominformation angezeigten tatsächlichen zeitlichen Verlauf des Stroms mit einem Referenzverlauf (wie z.B. in den Figuren 3a bis 3c, oder 4a bis 4c gezeigt) für den Schalt- und/oder Überprüfungsvorgang zu vergleichen. Dabei kann der Referenzverlauf einen zeitlichen Verlauf des Stroms bei einem erfolgreichen und/oder korrekten und/oder fehlerfreien Schalt- und/oder Überprüfungsvorgang anzeigen. Der Zustand des Magnetschalters kann dann in zuverlässiger und präziser Weise auf Basis des Vergleichs zwischen dem tatsächlichen zeitlichen Verlauf des Stroms und dem Referenzverlauf bestimmt werden.

Insbesondere kann die Steuereinheit eingerichtet sein, einen Wert eines Abstandsmaßes zwischen dem tatsächlichen zeitlichen Verlauf des Stroms und dem Referenzverlauf zu ermitteln. Das Abstandsmaß kann z.B. eine Standardabweichung, eine mittlere absolute Abweichung, eine maximale absolute Abweichung, und/oder eine mittlere quadratische Abweichung umfassen.

Die Steuereinheit kann eingerichtet sein, das Abstandsmaß bzw. einen Wert des Abstandsmaßes für die Gesamtdauer des tatsächlichen zeitlichen Verlaufs des Stroms ausgehend von dem Anfangszeitpunkt, ab dem der Strom durch die Spule ansteigt, bis zu dem Endzeitpunkt, ab dem der Strom durch die Spule im Wesentlichen konstant bleibt, zu ermitteln. Alternativ oder ergänzend kann die Steuereinheit eingerichtet sein, das Abstandsmaß bzw. einen Wert des Abstandsmaßes für ein oder mehrere Teilabschnitte des tatsächlichen zeitlichen Verlaufs des Stroms zu ermitteln.

Der Zustand des Magnetschalters kann dann in zuverlässiger und präziser Weise auf Basis der ein oder mehreren Werte des Abstandsmaßes (für die ein oder mehreren Teilabschnitte) bestimmt werden.

Die Steuereinheit kann eingerichtet sein, Werte für ein oder mehrere charakteristische Größen eines durch die Strominformation angezeigten tatsächlichen zeitlichen Verlaufs des Stroms zu ermitteln. Die ein oder mehreren charakteristischen Größen können zumindest einen zeitlichen Gradienten des tatsächlichen zeitlichen Verlaufs des Stroms in ein oder mehreren unterschiedlichen Teilabschnitten des tatsächlichen zeitlichen Verlaufs des Stroms umfassen. Alternativ oder ergänzend können die ein oder mehreren charakteristischen Größen die Zeitdauer des tatsächlichen zeitlichen Verlaufs des Stroms zwischen ein oder mehreren charakteristischen Zeitpunkten umfassen. Beispielhafte charakteristische Zeitpunkt sind: der Anfangszeitpunkt, ab dem der Strom durch die Spule ansteigt; der Endzeitpunkt, ab dem der Strom durch die Spule im Wesentlichen konstant bleibt; und/oder ein oder mehrere Zwischenzeitpunkte, an denen der Strom ein lokales und/oder globales Minimum oder Maximum aufweist.

Der Zustand des Magnetschalters (insbesondere der Hubmagnet oder der Verriegelungsmagnet) kann dann in zuverlässiger und präziser Weise auf Basis der Werte der ein oder mehreren charakteristischen Größen bestimmt werden.

Die Steuereinheit kann eingerichtet sein, eine Approximation des durch die Strominformation angezeigten tatsächlichen zeitlichen Verlaufs des Stroms durch eine analytische Funktion zu ermitteln, wobei die analytische Funktion ein oder mehrere Funktionsparameter aufweist. Eine beispielhafte analytische Funktion ist ein Polynom K^{ten} Grades, mit K>1, wobei die ein oder mehreren Funktionsparameter in diesem Fall die K Koeffizienten des Polynoms umfassen. Im Rahmen der Approximation können Werte für die ein oder mehreren Funktionsparameter ermittelt werden. Die Approximation kann derart erfolgen, dass der Werte eines Abstandsmaßes zwischen dem tatsächlichen zeitlichen Verlauf des Stroms und der approximierenden analytischen Funktion reduziert, insbesondere minimiert, wird.

Der Zustand des Magnetschalters kann dann in zuverlässiger und präziser Weise auf Basis von Werten der ein oder mehreren Funktionsparametern bestimmt werden.

Die Steuereinheit kann eingerichtet sein, die Ansteuerschaltung zu veranlassen, für einen ersten Schaltvorgang einen Strom mit einer ersten Polarität durch die Spule des Magnetschalters zu bewirken, um die Position des Bolzens des Magnetschalters zu verändern (z.B. von der ausgefahrenen Position zu der eingefahrenen Position, oder umgekehrt). Zu diesem Zweck kann eine Spannung mit der ersten Polarität an die Spule angelegt werden. Der erste Schaltvorgang ist z.B. abgeschlossen, wenn der Endzeitpunkt erreicht ist und/oder wenn eine vordefinierte Zeitdauer (z.B. zwischen 0,5 Sekunden und 2 Sekunden) abgelaufen ist.

Des Weiteren kann die Steuereinheit eingerichtet sein, die Ansteuerschaltung direkt infolge auf den ersten Schaltvorgang zu veranlassen, für einen Überprüfungsvorgang einen Strom mit der ersten Polarität durch die Spule des Magnetschalters zu bewirken. Zu diesem Zweck kann eine Spannung mit der ersten Polarität an die Spule angelegt werden. Es kann somit direkt im Anschluss an einen ersten Schaltvorgang ein Überprüfungsvorgang durchgeführt werden, um zu überprüfen, ob der erste Schaltvorgang korrekt durchgeführt wurde. Der Überprüfungsvorgang ist z.B. abgeschlossen, wenn der Endzeitpunkt erreicht ist und/oder wenn eine vordefinierte Zeitdauer (z.B. zwischen 0,01 Sekunden und 2 Sekunden) abgelaufen ist. Beispielsweise kann die Zeitdauer für einen Schaltvorgang des Magnetschalters im Bereich von 20ms (z.B. zwischen 10ms und 40ms) liegen. Der Schaltvorgang kann z.B. nach einer Zeitdauer von 50ms (z.B. zwischen 40ms und 80ms) als abgeschlossen betrachtet werden. Daraufhin kann dann ein Überprüfungsvorgang bewirkt werden (der z.B. eine vordefinierte Zeitdauer von 50ms, etwa zwischen 40ms und 80ms, aufweist).

Es kann dann in zuverlässiger und präziser Weise auf Basis der von der Messeinheit im Rahmen des Überprüfungsvorgangs erfassten Strominformation bestimmt werden, ob die Position des Bolzens während des ersten Schaltvorgangs tatsächlich (und dauerhaft) verändert wurde.

Gemäß einem weiteren Aspekt wird ein Hausgerät beschrieben, das eine verriegelbare Komponente mit einer Riegelvorrichtung umfasst, wobei die Riegelvorrichtung einen Magnetschalter mit einem Bolzen zum Entriegeln oder Verriegeln der Riegelvorrichtung aufweist. Das Hausgerät kann eine Küchenmaschine, insbesondere eine Küchenmaschine mit Kochfunktion, umfassen bzw. sein. Die verriegelbare Komponente kann einen Deckel zum Abdecken eines Behälters der Küchenmaschine umfassen.

Des Weiteren umfasst das Hausgerät das in diesem Dokument beschriebene System zum Betrieb des Magnetschalters. Das System ist eingerichtet, zu veranlassen, dass der Magnetschalter betätigt wird, um die Riegelvorrichtung zu verriegeln oder zu entriegeln. Des Weiteren ist das System eingerichtet, den Zustand des Magnetschalters zu ermitteln.

Die Erfindung umfasst des Weiteren ein Verfahren zum Betrieb eines Magnetschalters wie in Anspruch 10 definiert. Der Magnetschalter umfasst einen Bolzen, der zwischen einer aus einer Spule ausgefahrenen Position und einer in die Spule eingefahrenen Position bewegt werden kann. Das Verfahren umfasst das Bewirken eines Stroms durch die Spule des Magnetschalters für einen Schalt- und/oder Überprüfungsvorgang. Des Weiteren umfasst das Verfahren das Erfassen von Strominformation in Bezug auf einen zeitlichen Verlauf des Stroms durch die Spule während des Schalt- und des Überprüfungsvorgangs. Das Verfahren umfasst ferner das Bestimmen eines Zustands des Magnetschalters auf Basis der Strominformation.

Es ist zu beachten, dass jegliche Aspekte des in diesem Dokument beschriebenen Systems und/oder des beschriebenen Hausgeräts und/oder des beschriebenen Verfahrens in vielfältiger Weise miteinander kombiniert werden können. Insbesondere können die Merkmale der Patentansprüche in vielfältiger Weise miteinander kombiniert werden.

Im Weiteren wird die Erfindung anhand von in der beigefügten Zeichnung dargestellten Ausführungsbeispielen näher beschrieben. Dabei zeigen
- Figur 1: ein Blockdiagramm einer Küchenmaschine als Beispiel für ein Hausgerät;
- Figur 2a: ein beispielhaftes System zur Ansteuerung eines Magnetschalters (insbesondere eines Hubmagnets oder eines Verriegelungsmagnets);
- Figur 2b: einen Magnetschalter (insbesondere einen Hubmagnet oder eine Verriegelungsmagnet) in einem ausgefahrenen Zustand;
- Figur 2c: einen Magnetschalter (insbesondere einen Hubmagnet oder eine Verriegelungsmagnet) in einem eingefahrenen Zustand;
- Figuren: 3a bis 3c beispielhafte zeitliche Stromverläufe beim Übergang von dem ausgefahrenen Zustand in den eingefahrenen Zustand;
- Figuren: 4a bis 4c beispielhafte zeitliche Stromverläufe beim Übergang von dem eingefahrenen Zustand in den ausgefahrenen Zustand; und
- Figur 5: ein Ablaufdiagramm eines beispielhaften Verfahrens zur Ermittlung des Zustands eines Magnetschalters (insbesondere eines Hubmagnets oder eines Verriegelungsmagnets).

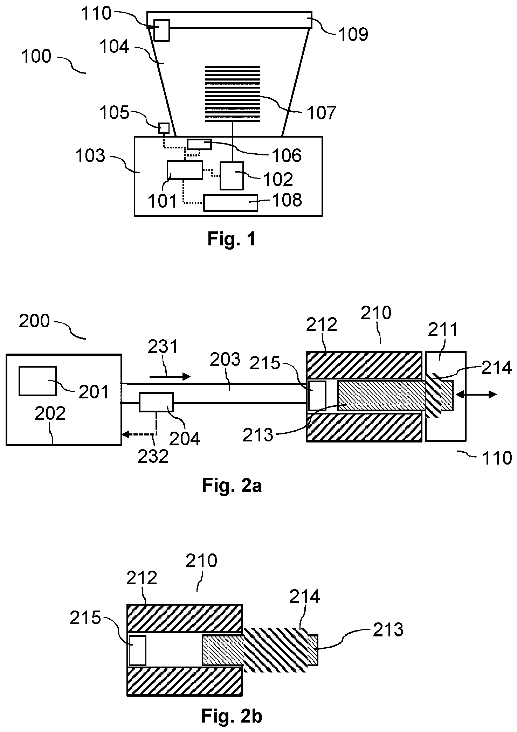

Wie eingangs dargelegt, befasst sich das vorliegende Dokument mit der zuverlässigen und effizienten Ermittlung des Zustands eines Magnetschalters, insbesondere um die Sicherheit eines Hausgeräts, etwa einer Küchenmaschine, zu erhöhen. In diesem Zusammenhang zeigt Fig. 1 eine beispielhafte Küchenmaschine 100 (als Beispiel für ein Hausgerät). Die in Fig. 1 dargestellte Küchenmaschine 100 umfasst einen Behälter 104, der auf einer Basis 103 der Küchenmaschine 100 angeordnet sein kann und in dem Zutaten für ein herzustellendes Nahrungsmittel verarbeitet werden können, z.B. mittels eines Werkzeugs bzw. Einsatzes 107, das bzw. der ggf. durch einen Motor 102 angetrieben wird. Dabei können ggf. unterschiedliche Werkzeuge 107 (z.B. ein Messer, ein Knethaken oder ein Besen) an dem Motor 102 montiert werden. Die Küchenmaschine 100 kann eingerichtet sein, den Behälter 104 mittels einer Temperierungseinheit 105 zu temperieren, z.B. zu kühlen oder zu erwärmen.

Des Weiteren kann die Küchenmaschine 100 ein oder mehrere Sensoren 106 umfassen, die eingerichtet sind, Sensordaten in Bezug auf die Küchenmaschine 100 (insbesondere in Bezug auf einen Zustand der Küchenmaschine 100) und/oder in Bezug auf das herzustellende Nahrungsmittel zu erfassen. Ein beispielhafter Sensor 106 ist ein Temperatursensor, der eingerichtet ist, Temperaturdaten in Bezug auf die Temperatur des Behälters 104 und/oder des darin enthaltenen Nahrungsmittels zu erfassen. Ein weiterer beispielhafter Sensor 106 ist ein Gewichtssensor bzw. eine Waage, der bzw. die eingerichtet ist, Gewichtsdaten in Bezug auf das Gewicht des Behälters 104 und/oder des darin enthaltenen Nahrungsmittels zu erfassen. Insbesondere können die Gewichtsdaten das Gewicht des Behälters 104 inklusive des in dem Behälter 104 enthaltenen Nahrungsmittels anzeigen. Da das Eigengewicht des Behälters 104 bekannt ist, kann mittels einer Tara-Funktion auf Basis der Gewichtsdaten das Gewicht des Nahrungsmittels in dem Behälter 104 ermittelt werden.

Außerdem kann die Küchenmaschine 100 eine Benutzerschnittstelle 108 umfassen, die es einem Nutzer ermöglicht, Steuereingaben an die Küchenmaschine 100 zu tätigen (z.B. über ein oder mehrere Knöpfe), und/oder die es der Küchenmaschine 100 ermöglicht, Rückmeldungen an einen Nutzer der Küchenmaschine 100 auszugeben (z.B. über einen Bildschirm). Insbesondere kann die Benutzerschnittstelle 108 dazu genutzt werden, Information in Bezug auf Arbeitsschritte eines Rezeptes zur Herstellung eines bestimmten Nahrungsmittels an einen Nutzer auszugeben.

Des Weiteren umfasst die Küchenmaschine 100 eine Steuereinheit 101, die eingerichtet sein kann, Rezeptdaten für ein Rezept zur Herstellung eines bestimmten Nahrungsmittels zu ermitteln (z.B. aus einer Speichereinheit der Küchenmaschine 100 auszulesen oder von einer Datenbank herunterzuladen). Ferner kann die Steuereinheit 101 eingerichtet sein, die Küchenmaschine 100 zumindest teilweise automatisch in Abhängigkeit von den Rezeptdaten zu betreiben, um den Nutzer bei der Herstellung des bestimmten Nahrungsmittels zu unterstützen.

Die Küchenmaschine 100 weist einen Deckel 109 zum Abdecken des Behälters 104 auf. Dabei kann der Deckel 109 mittels einer Riegelvorrichtung 110 verriegelt werden, um den Zugang zu dem Behälter 104 zu unterbinden. Beispielsweise kann die Steuereinheit 101 bestimmen, dass innerhalb des Behälters 104 ein Verarbeitungsschritt durchgeführt wird (z.B. das Scheiden eines Nahrungsmittels), bei dem der Deckel 109 des Behälters 104 verriegelt sein sollte. Die Steuereinheit 101 kann daraufhin die Riegelvorrichtung 110 veranlassen, den Deckel 109 zu verriegeln. Des Weiteren kann die Steuereinheit 101 eingerichtet sein, die Riegelvorrichtung 110 zu veranlassen, nach Beendigung des Verarbeitungsschrittes den Deckel 109 wieder zu entriegeln.

Fig. 2a zeigt ein beispielhaftes System 200 zum Betrieb einer Riegelvorrichtung 110 und/oder eines Magnetschalters 210. Die Riegelvorrichtung 110 umfasst einen Magnetschalter 210, der eingerichtet ist, einen Bolzen bzw. einen Riegel 213 durch eine translatorische Bewegung in ein Gegenstück 211 zu bewegen, um die Riegelvorrichtung 110 zu verriegeln, und/oder den Bolzen 213 durch eine entgegengesetzte translatorische Bewegung aus dem Gegenstück 211 heraus zu bewegen, um die Riegelvorrichtung 110 zu entriegeln.

Der Magnetschalter 210 umfasst eine Spule 212, die einen Hohlraum zur Aufnahme des Bolzens 213 umschließt. Die Spule 212 ist ausgebildet, ein Magnetfeld zu erzeugen, um auf den (ferromagnetischen) Bolzen 213 einzuwirken. Beispielsweise kann durch ein von der Spule 212 erzeugtes Magnetfeld bewirkt werden, dass der Bolzen 213 in den Magnetschalter 210 hineingezogen wird (und somit die Riegelvorrichtung 110 entriegelt wird). Ggf. kann der Magnetschalter 210 einen Permanentmagneten 215 aufweisen, der eingerichtet ist, den Magnetschalter 210 in dem eingefahrenen Zustand (mit eingefahrenem Bolzen 213) zu halten, auch wenn der Strom durch die Spule 212 unterbrochen wird.

Des Weiteren kann der Magnetschalter 210 eine Rückstellfeder 214 aufweisen, die eingerichtet ist, den Bolzen 213 aus dem Magnetschalter 210 heraus in einen ausgefahrenen Zustand (mit ausgefahrenem Bolzen 213) zu überführen, wenn durch die Spule 212 kein Magnetfeld bewirkt wird, das den Bolzen 213 in den Magnetschalter 210 hineinzieht. Die Spule 212 des Magnetschalters 210 kann ausgebildet sein, ein Magnetfeld zu erzeugen, dass ausreichend stark ist, um die Rückstellkraft der Rückstellfeder 214 zu überwinden, und um den Bolzen 213 in die eingefahrene Position zu bewegen. Des Weiteren kann die Spule 212 ausgebildet sein, ein ausreichend starkes Magnetfeld (mit einer umgekehrten Polarität) zu erzeugen, um die Rückhaltekraft des Permanentmagneten 215 zu überwinden, und um den Bolzen 213 in die ausgefahrene Position zu bewegen.

Es sei darauf hingewiesen, dass die Riegelvorrichtung 100 alternativ in umgekehrter Weise aufgebaut sein kann, so dass die Riegelvorrichtung 100 verriegelt ist, wenn sich der Magnetschalter 210 bzw. der Bolzen 213 im eingefahrenen Zustand befindet, und so dass die Riegelvorrichtung 100 entriegelt ist, wenn sich der Magnetschalter 210 bzw. der Bolzen 213 im ausgefahrenen Zustand befindet.

Fig. 2b zeigt den Magnetschalter 210 in dem ausgefahrenen Zustand, und Figur 2c zeigt den Magnetschalter 210 in dem eingefahrenen Zustand.

Das System 200 umfasst eine Ansteuerschaltung 202, die eingerichtet ist, bei Bedarf einen Strom 231 durch die Spule 212 des Magnetschalters 210 zu bewirken oder zu unterbinden. Die Ansteuerschaltung 202 kann durch eine Steuereinheit 201 (z.B. durch die Steuereinheit 201 des Hausgeräts 100) betrieben werden. Insbesondere kann die Steuereinheit 201 eingerichtet sein, die Ansteuerschaltung 202 zu veranlassen, einen ersten (z.B. einen positiven) Strom 231 zu bewirken, um den Magnetschalter 210 von dem ausgefahrenen Zustand in den eingefahrenen Zustand zu überführen. Der Magnetschalter 210 kann ggf. durch Verwendung eines Permanentmagneten 215 stromlos in dem eingefahrenen Zustand gehalten werden. Alternativ oder ergänzend kann die Steuereinheit 201 eingerichtet sein, die Ansteuerschaltung 202 zu veranlassen, einen zweiten (z.B. einen negativen) Strom 231 zu bewirken, um den Magnetschalter 210 von dem eingefahrenen Zustand in den ausgefahrenen Zustand zu überführen. Der erste und/oder zweite Strom 231 kann z.B. durch Anlegen einer ersten und/oder zweiten Spannung an der Spule 212 bewirkt werden.

Das System 200 kann eine Messeinheit 204 umfasst, die eingerichtet ist Strominformation in Bezug auf den durch die Spule 212 bewirkten Strom 231 zu erfassen. Die Messeinheit 204 kann z.B. einen Shunt-Widerstand, einen Hall Sensor und/oder einen Strom-Transformator umfassen. Die Messeinheit 204 und/oder die Steuereinheit 201 können eingerichtet sein, an einer Sequenz von Zeitpunkten t eine entsprechende Sequenz von Abtastwerten des Stroms 231 zu ermitteln, um einen zeitlichen Verlauf des Stroms 231 zu erfassen. Die Strominformation, insbesondere der zeitliche Verlauf des Stroms 231, kann (insbesondere von der Steuereinheit 201) dazu genutzt werden, den Zustand des Magnetschalters 210 zu ermitteln.

Im ausgefahrenen Zustand befindet sich der (ferromagnetische) Bolzen 213 des Magnetschalters 210 im Wesentlichen außerhalb der Spule 212, so dass der Kern der Spule 212 im Wesentlichen mit Luft gefüllt ist und somit eine relativ niedrige magnetische Permeabilität aufweist, so dass die Spule 212 eine relativ niedrige Induktivität L aufweist. Die relativ niedrige Induktivität L führt (aufgrund des Zusammenhangs di/dt=u/L, wobei i der Strom 231 durch die Spule 212, t die Zeit und u die Spannung an der Spule 212 ist) zu einem relativ hohen Stromgradienten.

Im eingefahrenen Zustand befindet sich der (ferromagnetische) Bolzen 213 des Magnetschalters 210 im Wesentlichen innerhalb der Spule 212, so dass der Kern der Spule 212 im Wesentlichen mit dem Material des Bolzens 213 gefüllt ist und somit eine relativ hohe magnetische Permeabilität aufweist, so dass die Spule 212 eine relativ hohe Induktivität L aufweist. Die relativ hohe Induktivität L führt zu einem relativ niedrigen Stromgradienten.

Somit kann der zeitliche Verlauf des Stroms 231 durch die Spule 212 in effizienter und zuverlässiger Weise als Indikator für den Zustand des Magnetschalters 210 verwendet werden.

Figuren 3a bis 3c zeigen beispielhafte zeitliche Verläufe 302 des Stroms 231 durch die Spule 212 des Magnetschalters 210 für einen ersten (z.B. einen Ein-) Schaltvorgang des Magnetschalters 210, bei dem der Magnetschalter 210 von dem ausgefahrenen Zustand in den eingefahrenen Zustand überführt werden soll. Insbesondere zeigt Fig. 3a einen zeitlichen Verlauf 302 des Stroms 231, bei dem tatsächlich eine Bewegung des Bolzens 213 von der ausgefahrenen Position zu der eingefahrenen Position erfolgt. Der Strom 231 steigt zunächst mit einem relativ hohen Gradienten 311 an (da sich der Bolzen 213 noch außerhalb der Spule 212 befindet). Sobald durch die Spule 212 ein Magnetfeld mit einer ausreichend hohen Kraft auf den Bolzen 213 bewirkt wird, bewegt sich der Bolzen 213. Durch die Bewegung des Bolzens 213 werden in der Spule 212 ein Magnetfeld und dadurch ein Induktionsstrom bewirkt. Dies führt zu einem Abfall des Stroms 231 (wie aus Fig. 3a zu entnehmen ist). Sobald der Bolzen 213 fest an der eingefahrenen Position steht, steigt der Strom 231 wieder an, diesmal jedoch (aufgrund der erhöhten Induktivität L der Spule 212) mit einem reduzierten Gradienten 312. Der erste Schaltvorgang kann an dem Zeitpunkt 303, ab dem keine wesentliche Veränderung des Stroms 231 mehr erfolgt, als beendet betrachtet werden. Der in Fig. 3a dargestellte zeitliche Verlauf 302 kann als Referenzverlauf für einen erfolgreichen ersten Schaltvorgang betrachtet werden.

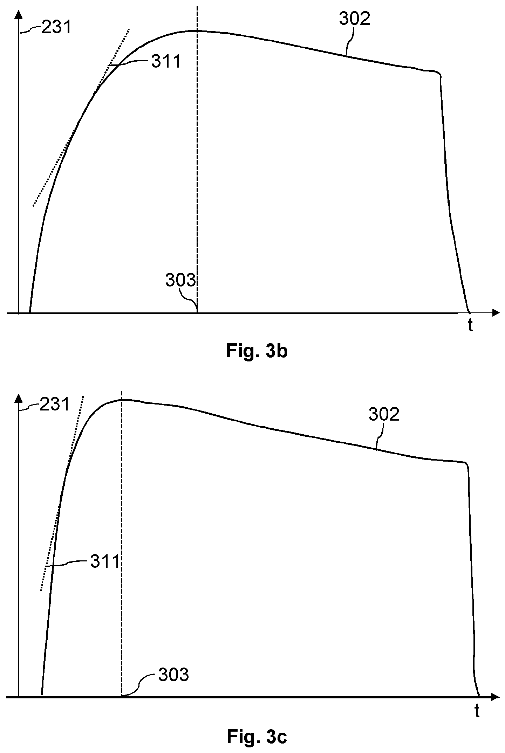

Die Steuereinheit 201 kann eingerichtet sein, (direkt) nachfolgenden zu dem ersten Schaltvorgang einen Überprüfungsvorgang durchzuführen, bei dem erneut ein Strom 231 für einen ersten Schaltvorgang durch die Spule 212 bewirkt wird (d.h. mit der gleichen Polarität). Für den Überprüfungsvorgang kann wiederum anhand der Messeinheit 204 Strominformation erfasst werden, die den zeitlichen Verlauf 302 des Stroms 231 während des Überprüfungsvorgangs anzeigt. Fig. 3b zeigt einen zeitlichen Verlauf 302 für den Fall, dass sich der Bolzen 213 (in korrekter Weise) in der eingefahrenen Position befindet, und der zeitliche Verlauf 302 des Stroms 231 daher einen relativ niedrigen Stromgradienten 311 aufweist (aufgrund der relativ hohen Induktivität L der Spule 212). Andererseits zeigt Fig. 3c einen zeitlichen Verlauf 302 für den Fall, dass sich der Bolzen 213 (fehlerhaft) in der ausgefahrenen Position befindet, und der zeitliche Verlauf 302 des Stroms 231 daher einen relativ hohen Stromgradienten 311 aufweist (aufgrund der relativ niedrigen Induktivität L des Spule 212). Mittels eines auf den ersten Schaltvorgang folgenden Überprüfungsvorgang kann somit in zuverlässiger Weise der Zustand eines Magnetschalters 210 überprüft werden. Die in den Figuren 3b und 3c dargestellten zeitlichen Verläufe 302 können dabei jeweils als Referenzverlauf für einen Überprüfungsvorgang betrachtet werden.

Figuren 4a bis 4c zeigen beispielhafte zeitliche Verläufe 302 des Stroms 231 durch die Spule 212 des Magnetschalters 210 für einen zweiten (z.B. einen Aus-) Schaltvorgang des Magnetschalters 210, bei dem der Magnetschalter 210 von dem eingefahrenen Zustand in den ausgefahrenen Zustand überführt werden soll. Insbesondere zeigt Fig. 4a einen zeitlichen Verlauf 302 des Stroms 231, bei dem tatsächlich eine Bewegung des Bolzens 213 von der eingefahrenen Position zu der ausgefahrenen Position erfolgt. Zunächst erfolgt ein Anstieg des Stroms 231 mit einem relativ niedrigen Stromgradienten 311 (da die Spule 212 aufgrund des eingefahrenen Bolzens 213 eine relativ hohe Induktivität aufweist). Sobald die Rückhaltkraft des Permanentmagneten 215 überwunden ist, erfolgt eine Bewegung des Bolzens 213, wodurch ein Magnetfeld und damit ein Induktionsstrom in der Spule 212 bewirkt wird. Als Folge daraus kommt es zu einer Überhöhung des Stroms 231 (über den Nominalstrom der Spule 212 hinaus). Der Strom 231 fällt nach Beendigung der Bewegung des Bolzens 213 wieder auf den Nominalstrom der Spule 212 ab. Der in Fig. 4a dargestellte zeitliche Verlauf 302 kann als Referenzverlauf für einen erfolgreichen zweiten Schaltvorgang betrachtet werden.

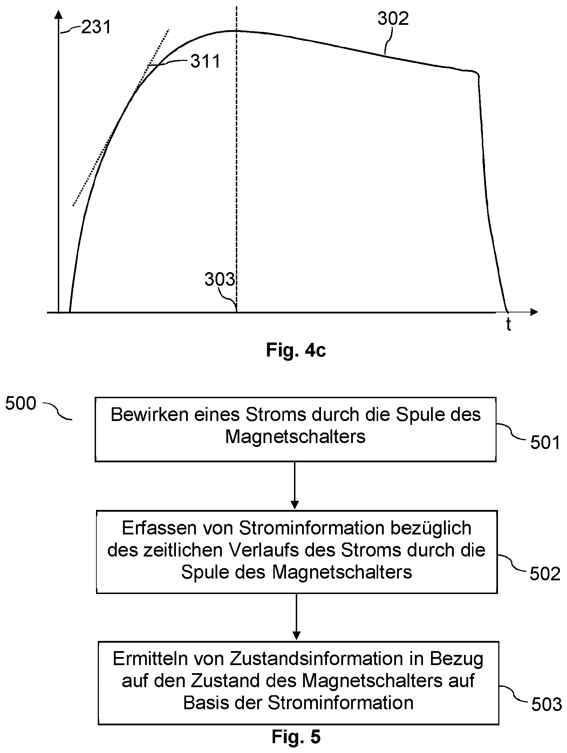

Auch (direkt) im Anschluss an einen zweiten Schaltvorgang kann ein Überprüfungsvorgang durchgeführt werden, bei dem in der Spule 212 ein Strom 231 für einen zweiten Schaltvorgang veranlasst wird (obwohl sich der Magnetschalter 210 bereits in dem ausgefahrenen Zustand befinden sollte). Fig. 4b zeigt einen zeitlichen Verlauf 302 mit einem relativ hohen Stromgradienten 311, der anzeigt, dass sich der Magnetschalter 210 korrekter Weise im ausgefahrenen Zustand befindet. Der in Fig. 4b dargestellte zeitliche Verlauf 302 entspricht dem in Fig. 3c gezeigten Verlauf 302, jedoch mit einer umgekehrten Polarität. Fig. 4c zeigt einen zeitlichen Verlauf 302 mit einem relativ niedrigen Stromgradienten 311, der anzeigt, dass sich der Magnetschalter 210 fehlerhaft weiterhin im eingefahrenen Zustand befindet. Der in Fig. 4c dargestellte zeitliche Verlauf 302 entspricht dem in Fig. 3b gezeigten Verlauf 302, jedoch mit einer umgekehrten Polarität. Mittels eines auf den zweiten Schaltvorgang folgenden Überprüfungsvorgang kann somit in zuverlässiger Weise der Zustand eines Magnetschalters 210 überprüft werden.

Die Steuereinheit 101, 201 kann eingerichtet sein, bei einem Schalt- und/oder Überprüfungsvorgang den tatsächlichen zeitlichen Verlauf 302 des Stroms 231 durch die Spule 212 zu ermitteln. Des Weiteren kann die Steuereinheit 101, 201 eingerichtet sein, den Zustand des Magnetschalters 210 auf Basis des tatsächlichen zeitlichen Verlaufs 302 des Stroms 231 zu bestimmen. Zu diesem Zweck kann der tatsächliche zeitliche Verlauf 302 des Stroms 231 mit einem Referenzverlauf verglichen werden. Der Zustand kann dann auf Basis des Vergleichs ermittelt werden. Beispielsweise kann der Wert eines Abstandsmaßes (z.B. der quadratischen mittleren Abweichung) zwischen dem tatsächlichen zeitlichen Verlauf 302 des Stroms 231 und dem Referenzverlauf ermittelt werden. Der Zustand kann dann in präziser Weise auf Basis des Wertes des Abstandsmaßes ermittelt werden.

Alternativ oder ergänzend können ein oder mehrere charakteristische Größen des tatsächlichen zeitlichen Verlaufs 302 des Stroms 231 ermittelt werden. Beispielhafte charakteristische Größen sind:
- die Zeitdauer des tatsächlichen zeitlichen Verlaufs 302 des Stroms 231 (bis zum Erreichen eines im wesentlichen stabilen Stroms 231, z.B. bis zum Erreichen des Zeitpunkts 303); und/oder
- der Gradient 311, 312 des Stroms 231 in ein oder mehreren Teilabschnitten des tatsächlichen zeitlichen Verlaufs 302 des Stroms 231.

Der Zustand des Magnetschalters 210 kann dann in zuverlässiger Weise auf Basis der ein oder mehreren charakteristischen Größen des tatsächlichen zeitlichen Verlaufs 302 des Stroms 231 bestimmt werden.

Fig. 5 zeigt ein Ablaufdiagramm eines beispielhaften Verfahrens 500 zum Betrieb eines Magnetschalters 210. Der Magnetschalter 210 umfasst einen (ferromagnetischen) Bolzen 213, der zwischen einer aus einer Spule 212 ausgefahrenen Position und einer in die Spule 212 eingefahrenen Position bewegt werden kann (z.B. um eine Riegelvorrichtung 110 zu verriegeln oder zu entriegeln). Der Magnetschalter 210 kann bistabil ausgebildet sein, so dass der Magnetschalter 210 stromlos in dem ausgefahrenen Zustand (bei dem der Bolzen 213 in der ausgefahrenen Position angeordnet ist) und in dem eingefahrenen Zustand (bei dem der Bolzen 213 in der eingefahrenen Position angeordnet ist) gehalten werden kann. Das Verfahren 500 kann durch eine Steuereinheit 101, 201 eines Hausgeräts 100 und/oder eines Systems 200 ausgeführt werden.

Das Verfahren 500 umfasst das Bewirken 501 eines Stroms 231 durch die Spule 212 des Magnetschalters 210 für einen Schalt- und/oder Überprüfungsvorgang des Magnetschalters 210. Der Strom 231 kann z.B. durch Anlegen einer Spannung an der Spule 212 bewirkt werden. Dabei kann durch Anlegen einer ersten Spannung mit einer ersten Polarität ein Strom 231 mit einer ersten Polarität (z.B. einer positiven Polarität) bewirkt werden. Andererseits kann durch Anlegen einer zweiten Spannung mit einer entgegengesetzten zweiten Polarität ein Strom 231 mit einer entgegengesetzten zweiten Polarität (z.B. einer negativen Polarität) bewirkt werden. Ein Strom mit der ersten Polarität kann z.B. verwendet werden, um den Bolzen 213 von der eingefahrenen Position in die ausgefahrene Position zu bewegen, und ein Strom mit der zweiten Polarität kann z.B. verwendet werden, um den Bolzen 213 von der ausgefahrenen Position in die eingefahrene Position zu bewegen (oder umkehrt).

Des Weiteren umfasst das Verfahren 500 das Erfassen 502 von Strominformation in Bezug auf den zeitlichen Verlauf 302 des Stroms 231 durch die Spule 212 während des Schalt- und/oder Überprüfungsvorgangs. Der zeitliche Verlauf 302 kann z.B. durch eine Sequenz von Abtastwerten des Stroms 231 beschrieben werden (z.B. von 1000 Abtastwerten/Sekunde oder mehr).

Außerdem umfasst das Verfahren 500 das Bestimmen 503 des Zustands des Magnetschalters 210 auf Basis der Strominformation. Beispielhafte Zustände sind dabei
- der Magnetschalter 210 befindet sich korrekter Weise in dem ausgefahrenen Zustand;
- der Magnetschalter 210 befindet sich fehlerhaft in dem ausgefahrenen Zustand;
- der Magnetschalter 210 befindet sich korrekter Weise in dem eingefahrenen Zustand; und/oder
- der Magnetschalter 210 befindet sich fehlerhaft in dem eingefahrenen Zustand;

Durch die in diesem Dokument beschriebenen Maßnahmen kann in effizienter Weise (ohne einen weiteren Zustandsensor), der Zustand eines Magnetschalters 210 bestimmt werden. So können die Kosten, das Gewicht und der erforderliche Bauraum für ein Hausgerät 100 reduziert werden.

Die vorliegende Erfindung ist nicht auf die gezeigten Ausführungsbeispiele beschränkt. Insbesondere ist zu beachten, dass die Beschreibung und die Figuren nur das Prinzip des vorgeschlagenen Systems und/oder des vorgeschlagenen Hausgeräts und/oder des vorgeschlagenen Verfahrens veranschaulichen sollen.

## Patentansprüche

1. System (200) zum Betrieb eines Magnetschalters (210); wobei der Magnetschalter (210) einen Bolzen (213) umfasst, der zwischen einer aus einer Spule (212) ausgefahrenen Position und einer in die Spule (212) eingefahrenen Position bewegt werden kann; wobei das System (200) umfasst,
- eine Ansteuerschaltung (202), die eingerichtet ist, einen Strom (231) durch die Spule (212) des Magnetschalters (210) zu bewirken;
- eine Messeinheit (204), die eingerichtet ist, Strominformation in Bezug auf einen zeitlichen Verlauf (302) des Stroms (231) durch die Spule (212) zu erfassen; und
- eine Steuereinheit (201), die eingerichtet ist,
- die Ansteuerschaltung (202) zu veranlassen, für einen ersten Schaltvorgang einen Strom (231) mit einer ersten Polarität durch die Spule (212) des Magnetschalters (210) zu bewirken, um die Position des Bolzens (213) des Magnetschalters (210) zu verändern; und
**dadurch gekennzeichnet , dass** die Steuereinheit (201) weiterhin dazu eingerichtet ist,
- die Ansteuerschaltung (202) direkt infolge darauf zu veranlassen, für einen Überprüfungsvorgang einen Strom (231) mit der ersten Polarität durch die Spule (212) des Magnetschalters (210) zu bewirken;
- einen Wert eines Abstandsmaßes zwischen einem durch die Strominformation angezeigten tatsächlichen zeitlichen Verlauf (302) des für den Überprüfungsvorgang bewirkten Stroms (231) und einem Referenzverlauf für den Überprüfungsvorgang zu ermitteln; und
- auf Basis des Wertes des Abstandsmaßes zu bestimmen, ob die Position des Bolzens (213) während des ersten Schaltvorgangs tatsächlich verändert wurde.

2. System (200) gemäß Anspruch 1, wobei das Abstandsmaß eine Standardabweichung, eine mittlere absolute Abweichung, eine maximale absolute Abweichung, und/oder eine mittlere quadratische Abweichung umfasst.

3. System (200) gemäß einem der Ansprüche 1 bis 2, wobei die Steuereinheit (201) eingerichtet ist, das Abstandsmaß zu ermitteln,
- für eine Gesamtdauer des tatsächlichen zeitlichen Verlaufs (302) des Stroms (231) ausgehend von einem Anfangszeitpunkt, ab dem der Strom (231) durch die Spule (212) ansteigt, bis zu einem Endzeitpunkt (303), ab dem der Strom (231) durch die Spule (212) im Wesentlichen konstant bleibt; und/oder
- für ein oder mehrere Teilabschnitte des tatsächlichen zeitlichen Verlaufs (302) des Stroms (231).

4. System (200) gemäß einem der vorhergehenden Ansprüche; wobei die Steuereinheit (201) eingerichtet ist,
- die Ansteuerschaltung (202) zu veranlassen, für einen Schaltvorgang einen Strom (231) mit einer bestimmten Polarität durch die Spule (212) des Magnetschalters (210) zu bewirken, um den Bolzen (213) des Magnetschalters (210) von der eingefahrenen Position zu der ausgefahrenen Position zu bewegen; und
- die Ansteuerschaltung (202) zu veranlassen, für einen Schaltvorgang einen Strom (231) mit einer zu der bestimmten Polarität entgegengesetzten Polarität durch die Spule (212) des Magnetschalters (210) zu bewirken, um den Bolzen (213) des Magnetschalters (210) von der ausgefahrenen Position zu der eingefahrenen Position zu bewegen.

5. System (200) gemäß einem der vorhergehenden Ansprüche; wobei die Steuereinheit (201) eingerichtet ist, die Ansteuerschaltung (202) zu veranlassen, für einen Schalt- und/oder Überprüfungsvorgang eine Spannung mit einer ersten Polarität oder mit einer zweiten Polarität an die Spule (212) des Magnetschalters (210) anzulegen.

6. System (200) gemäß einem der vorhergehenden Ansprüche; wobei die Steuereinheit (201) eingerichtet ist,
- Werte für ein oder mehrere charakteristische Größen des durch die Strominformation angezeigten tatsächlichen zeitlichen Verlaufs (302) des Stroms (231) zu ermitteln; und
- den Zustand des Magnetschalters (210) auf Basis der Werte der ein oder mehreren charakteristischen Größen zu ermitteln.

7. System (200) gemäß Anspruch 6; wobei die ein oder mehreren charakteristischen Größen umfassen,
- einen zeitlichen Gradienten (311, 312) des tatsächlichen zeitlichen Verlaufs (302) des Stroms (231) in ein oder mehreren unterschiedlichen Teilabschnitten des tatsächlichen zeitlichen Verlaufs (302) des Stroms (231); und/oder
- eine Zeitdauer des tatsächlichen zeitlichen Verlaufs (302) des Stroms (231) zwischen ein oder mehreren charakteristischen Zeitpunkten; wobei die ein oder mehreren charakteristischen Zeitpunkte umfassen:
- einen Anfangszeitpunkt, ab dem der Strom (231) durch die Spule (212) ansteigt,
- einen Endzeitpunkt (303), ab dem der Strom (231) durch die Spule (212) im Wesentlichen konstant bleibt, und/oder
- eine Zwischenzeitpunkt, an dem der Strom (231) ein lokales und/oder globales Minimum oder Maximum aufweist.

8. Hausgerät (100), das umfasst,
- eine verriegelbare Komponente (104, 109) mit einer Riegelvorrichtung (110); wobei die Riegelvorrichtung (110) einen Magnetschalter (210), insbesondere einen Hubmagneten oder einen Verriegelungsmagneten, mit einem Bolzen (213) zum Entriegeln oder Verriegeln der Riegelvorrichtung (110) umfasst; und
- ein System (200) gemäß einem der vorhergehenden Ansprüche, das eingerichtet ist,
- zu veranlassen, dass der Magnetschalter (210) betätigt wird, um die Riegelvorrichtung (110) zu verriegeln oder zu entriegeln; und
- den Zustand des Magnetschalters (210) zu ermitteln.

9. Hausgerät (100) gemäß Anspruch 8, wobei
- das Hausgerät (100) eine Küchenmaschine umfasst; und
- die verriegelbare Komponente (104, 109) einen Deckel (109) zum Abdecken eines Behälters (104) der Küchenmaschine umfasst.

10. Verfahren (500) zum Betrieb eines Magnetschalters (210); wobei der Magnetschalter (210) einen Bolzen (213) umfasst, der zwischen einer aus einer Spule (212) ausgefahrenen Position und einer in die Spule (212) eingefahrenen Position bewegt werden kann; wobei das Verfahren (500) umfasst,
- Bewirken eines Stroms (231) mit einer ersten Polarität durch die Spule (212) des Magnetschalters (210) für einen ersten Schaltvorgang, um die Position des Bolzens (213) des Magnetschalters (210) zu verändern;
**dadurch gekennzeichnet, dass** das Verfahren weiterhin umfasst:
- Bewirken (501), direkt infolge darauf, eines Stroms (231) mit der ersten Polarität durch die Spule (212) des Magnetschalters (210) für einen Überprüfungsvorgang;
- Erfassen (502) von Strominformation in Bezug auf einen zeitlichen Verlauf (302) des Stroms (231) durch die Spule (212) während des Überprüfungsvorgangs;
- Ermitteln eines Wertes eines Abstandsmaßes zwischen einem durch die Strominformation angezeigten tatsächlichen zeitlichen Verlauf (302) des Stroms (231) und einem Referenzverlauf für den Überprüfungsvorgang; und
- Bestimmen (503), auf Basis des Wertes des Abstandsmaßes, ob die Position des Bolzens (213) während des ersten Schaltvorgangs tatsächlich verändert wurde.

## Claims

1. System (200) for operating a magnetic switch (210); wherein the magnetic switch (210) comprises a pin (213) which can be moved between a position extended out of a coil (212) and a position retracted into the coil (212), wherein the system (200) comprises;
- a control circuit (202) which is configured to effect a current (231) through the coil (212) of the magnetic switch (210);
- a measuring unit (204) which is configured to acquire information relating to the current with regard to a temporal profile (302) of the current (231) through the coil (212); and
- a control unit (201) which is configured:
- to cause the control circuit (202) to effect, for a first switching procedure, a current (231) with a first polarity through the coil (212) of the magnetic switch (210) in order to change the position of the pin (213) of the magnetic switch (210), and
**characterised in that** the control unit (201) is furthermore configured so as:
- to cause the control circuit (202) directly in response thereto to effect, for a checking procedure, a current (231) with the first polarity through the coil (212) of the magnetic switch (210);
- to ascertain a value of a distance measure between an actual temporal profile (302) of the current (231) effected for the checking procedure, the actual temporal profile being indicated by the information relating to the current, and a reference profile for the checking procedure; and
- on the basis of the value of the distance measure to determine whether the position of the pin (213) was actually changed during the first switching procedure.

2. System (200) according to claim 1, wherein the distance measure comprises a standard deviation, a mean absolute deviation, a maximum absolute deviation, and/or a mean quadratic deviation.

3. System (200) according to one of claims 1 to 2, wherein the control unit (201) is configured to determine the distance measure
- for a total time duration of the actual temporal profile (302) of the current (231) starting from a starting point in time from which point on the current (231) through the coil (212) increases until an ending point in time (303) from which point on the current (231) through the coil (212) remains substantially constant; and/or
- for one or more sub-sections of the actual temporal profile (302) of the current (231).

4. System (200) according to one of the preceding claims; wherein the control unit (201) is configured:
- to cause the control circuit (202) to effect, for a switching procedure, a current (231) with a specific polarity through the coil (212) of the magnetic switch (210) in order to move the pin (213) of the magnetic switch (210) from the retracted position into the extended position; and
- to cause the control circuit (202) to effect, for a switching procedure, a current (231) with a polarity opposite the specific polarity through the coil (212) of the magnetic switch (210) in order to move the pin (213) of the magnetic switch (210) from the extended position into the retracted position.

5. System (200) according to one of the preceding claims; wherein the control unit (201) is configured to cause the control circuit (202) to apply a voltage with a first polarity or with a second polarity to the coil (212) of the magnetic switch (210) for a switching and/or checking procedure.

6. System (200) according to one of the preceding claims; wherein the control unit (201) is configured:
- to ascertain values for one or more characteristic variables of the actual temporal profile (302) of the current (231) indicated by the information relating to the current; and
- to determine the state of the magnetic switch (210) on the basis of the values of the one or more characteristic variables.

7. System (200) according to claim 6; wherein the one or more characteristic variables comprise:
- a temporal gradient (311, 312) of the actual temporal profile (302) of the current (231) in one or more different sub-sections of the actual temporal profile (302) of the current (231); and/or
- a time duration of the actual temporal profile (302) of the current (231) between one or more characteristic points in time; wherein the one or more characteristic points in time comprise:
- a starting point in time from which point on the current (231) through the coil (212) increases,
- an ending point in time (303) from which point on the current (231) through the coil (212) remains substantially constant, and/or
- an intermediate point in time at which the current (231) has a local and/or global minimum or maximum.

8. Household appliance (100), which comprises
- a lockable component (104, 109) having a locking apparatus (110); wherein the locking apparatus (110) comprises a magnetic switch (210), in particular a lifting magnet or a locking magnet, a pin (213) for unlocking and locking the locking apparatus (110); and
- a system (200) according to one of the preceding claims, which is configured
- to cause the magnetic switch (210) to be actuated in order to lock or unlock the locking apparatus (110); and
- to determine the state of the magnetic switch (210).

9. Household appliance (100) according to claim 8, wherein
- the household appliance (100) comprises a food processor; and
- the lockable component (104, 109) comprises a lid (109) for covering a container (104) of the food processor.

10. Method (500) for operating a magnetic switch (210); wherein the magnetic switch (210) comprises a pin (213), which can be moved between a position extended out of a coil (212) and a position retracted into the coil (212), wherein the method (500) comprises
- effecting a current (231) with a first polarity through the coil (212) of the magnetic switch (210) for a first switching procedure in order to change the position of the pin (213) of the magnetic switch (210);
**characterised in that** the method further comprises:
- effecting (501) directly in response thereto a current (231) with the first polarity through the coil (212) of the magnetic switch (210) for a checking procedure;
- acquiring (502) information relating to the current with regard to a temporal profile (302) of the current (231) through the coil (212) during the checking procedure;
- ascertaining a value of a distance measure between an actual temporal profile (302) of the current (231), the actual temporal profile being indicated by the information relating to the current, and a reference profile for the checking procedure; and
- determining (503) on the basis of the value of the distance measure whether the position of the pin (213) was actually changed during the first switching procedure.

## Revendications

1. Système (200) permettant de faire fonctionner un interrupteur magnétique (210) ;
dans lequel l'interrupteur magnétique (210) comprend un axe (213) qui peut être déplacé entre une position de sortie d'une bobine (212) et une position de rentrée dans la bobine (212) ; dans lequel le système (200) comprend :
- un circuit de commande (202) conçu afin de faire passer un courant (231) à travers la bobine (212) de l'interrupteur magnétique (210) ;
- une unité de mesure (204) conçue afin d'enregistrer des informations de courant relatives à une évolution temporelle (302) du courant (231) à travers la bobine (212) ; et
- une unité de commande (201) conçue afin de :
- en vue d'une première opération de commutation, amener le circuit de commande (202) à faire passer un courant (231) avec une première polarité à travers la bobine (212) de l'interrupteur magnétique (210) afin de modifier la position de l'axe (213) de l'interrupteur magnétique (210) ; et
**caractérisé en ce que** l'unité de commande (201) est en outre conçue afin de :
- immédiatement suite à cela et en vue d'une opération de vérification, amener le circuit de commande (202) à faire passer un courant (231) avec la première polarité à travers la bobine (212) de l'interrupteur magnétique (210) ;
- déterminer une valeur d'une mesure de distance entre une évolution temporelle réelle (302), indiquée par les informations de courant, du courant (231) provoqué par l'opération de vérification et une évolution de référence pour l'opération de vérification ; et
- en se basant sur la valeur de la mesure de distance, déterminer si la position de l'axe (213) a effectivement été modifiée au cours de la première opération de commutation.

2. Système (200) selon la revendication 1, dans lequel la mesure de distance comprend un écart type, un écart absolu moyen, un écart absolu maximal et/ou un écart quadratique moyen.

3. Système (200) selon la revendication 1 ou 2, dans lequel l'unité de commande (201) est conçue afin de déterminer la mesure de distance,
- pour une durée totale de l'évolution temporelle réelle (302) du courant (231) à partir d'un instant de départ à partir duquel le courant (231) traversant la bobine (212) augmente jusqu'à un instant final (303) à partir duquel le courant (231) traversant la bobine (212) reste essentiellement constant ; et/ou
- pour une ou plusieurs sous-partie(s) de l'évolution temporelle réelle (302) du courant (231).

4. Système (200) selon l'une quelconque des revendications précédentes ; dans lequel l'unité de commande (201) est conçue afin de :
- en vue d'une opération de commutation, amener le circuit de commande (202) à faire passer un courant (231) avec une polarité définie à travers la bobine (212) de l'interrupteur magnétique (210) afin de déplacer l'axe (213) de l'interrupteur magnétique (210) de la position de rentrée à la position de sortie ; et
- en vue d'une opération de commutation, amener le circuit de commande (202) à faire passer un courant (231) avec une polarité opposée à la polarité définie à travers la bobine (212) de l'interrupteur magnétique (210) afin de déplacer l'axe (213) de l'interrupteur magnétique (210) de la position de sortie à la position de rentrée.

5. Système (200) selon l'une quelconque des revendications précédentes ; dans lequel l'unité de commande (201) est conçue afin de, en vue d'une opération de commutation et/ou de vérification, amener le circuit de commande (202) à appliquer une tension avec une première polarité ou avec une deuxième polarité à la bobine (212) de l'interrupteur magnétique (210).

6. Système (200) selon l'une quelconque des revendications précédentes ; dans lequel l'unité de commande (201) est conçue afin de :
- déterminer des valeurs pour une ou plusieurs grandeur(s) caractéristique(s) de l'évolution temporelle réelle (302) du courant (231) indiquée par l'information de courant ; et
- déterminer l'état de l'interrupteur magnétique (210) en se basant sur les valeurs d'une ou plusieurs grandeur(s) caractéristique(s).

7. Système (200) selon la revendication 6 ; dans lequel la ou les grandeur(s) caractéristique(s) comprend ou comprennent :
- un gradient temporel (311, 312) de l'évolution temporelle réelle (302) du courant (231) dans une ou plusieurs sous-parties différentes de l'évolution temporelle réelle (302) du courant (231) ; et/ou
- une durée de l'évolution temporelle réelle (302) du courant (231) entre un ou plusieurs instant(s) caractéristique(s) ; le ou les instant(s) caractéristique(s) comprenant :
- un point de départ à partir duquel le courant (231) traversant la bobine (212) augmente,
- un instant de fin (303) à partir duquel le courant (231) traversant la bobine (212) reste essentiellement constant ; et/ou
- un instant intermédiaire auquel le courant (231) présente un minimum ou un maximum local et/ou global.

8. Appareil ménager (100) comprenant :
- un composant verrouillable (104, 109) avec un dispositif de verrouillage (110) ; dans lequel le dispositif de verrouillage (110) comprend un interrupteur magnétique (210), en particulier un aimant de levage ou un aimant de verrouillage, avec un axe (213) permettant de déverrouiller ou verrouiller le dispositif de verrouillage (110) ; et
- un système (200) selon l'une quelconque des revendications précédentes, qui est conçu afin de :
- actionner l'interrupteur magnétique (210) afin de verrouiller ou de déverrouiller le dispositif de verrouillage (110) ; et
- déterminer l'état de l'interrupteur magnétique (210).

9. Procédé (100) selon la revendication 8, dans lequel :
- l'appareil ménager (100) comprend un robot culinaire ; et
- le composant verrouillable (104, 109) comprend un couvercle (109) permettant de recouvrir un récipient (104) du robot culinaire.

10. Procédé (500) permettant de faire fonctionner un interrupteur magnétique (210) ;
dans lequel l'interrupteur magnétique (210) comprend un axe (213) qui peut être déplacé entre une position de sortie d'une bobine (212) et une position de rentrée dans la bobine (212) ; dans lequel le procédé (500) comprend :
- en vue d'une première opération de commutation, faire passer un courant (231) avec une première polarité à travers la bobine (212) de l'interrupteur magnétique (210) afin de modifier la position de l'axe (213) de l'interrupteur magnétique (210) ;
**caractérisé en ce que** le procédé comprend en outre :
- immédiatement suite à cela, faire passer (501) un courant (231) avec la première polarité à travers la bobine (212) de l'interrupteur magnétique (210) en vue d'une opération de vérification ;
- enregistrer (502) des informations de courant relatives à une évolution temporelle (302) du courant (231) à travers la bobine (212) pendant l'opération de vérification ;
- déterminer une valeur d'une mesure de distance entre une évolution temporelle réelle (302) du courant (231) indiqué par les informations de courant et une évolution de référence pour l'opération de vérification ; et
- déterminer (503), en se basant sur la valeur de la mesure de distance, si la position de l'axe (213) a effectivement été modifiée au cours de la première opération de commutation.
